**Europäisches Patentamt**

**European Patent Office**

**Office européen des brevets**

(11) Veröffentlichungsnummer: **0 387 378 A1**

## (12) EUROPÄISCHE PATENTANMELDUNG

(21) Anmeldenummer: **89104714.4**

(51) Int. Cl.5: **G11C 11/24**

(22) Anmeldetag: **16.03.89**

(43) Veröffentlichungstag der Anmeldung:
**19.09.90 Patentblatt 90/38**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Hoffmann, Kurt, Prof. Dr.**
**Nelkenweg 20**
**D-8028 Taufkirchen(DE)**
Erfinder: **Kraus, Rainer, Dr.**
**Weidener Strasse 21**
**D-8000 München 83(DE)**
Erfinder: **Kowarik, Oskar, Dr.**
**Goethering 70**
**D-8018 Grafing(DE)**

(54) **Integrierter Halbleiterspeicher vom Typ DRAM und Verfahren zu seinem Testen.**

(57) Ein integrierter Halbleiterspeicher weist je Bitleitung BL und je Referenzbitleitung $\overline{BL}$ eines Bitleitungspaares eine Koppelkapazität CK auf. Im Testbetrieb sind nach einem Vorladen t1 des Bitleitungspaares mittels eines Testsignals Test zusätzliche Potentiale $\Delta VPC1$, $\Delta VPC2$ auf das Bitleitungspaar BL, $\overline{BL}$ einkoppelbar ($t_{CK}$). Dies ermöglicht eine einfache Analyse von Speicherzellen MC und Bewerterschaltungen AMP des Halbleiterspeichers und eröffnet neue Analysemöglichkeiten.

FIG 3

EP 0 387 378 A1

## Integrierter Halbleiterspeicher vom Typ DRAM und Verfahren zu seinem Testen

Die vorliegende Erfindung betrifft einen integrierten Halbleiterspeicher vom Typ DRAM nach dem Oberbegriff des Patentanspruches 1 sowie ein Verfahren zum Testen eines Halbleiterspeichers nach dem Oberbegriff des Patentanspruches 15.

Gattungsgemäße integrierte Halbleiterspeicher sind beispielsweise aus folgenden Veröffentlichungen bekannt:

- IEEE Journal of Solid-State Circuits, Vol. SC-20, No. 5, October 1985, Seiten 903 bis 908, "A 1-Mbit CMOS DRAM with fast Page Mode and Static Column Mode". Die Veröffentlichung offenbart einen gattungsgemäßen integrierten Halbleiterspeicher mit sog. "complementary capacitor coupled dummy cells". Als Dummy-Zellen sind dabei auch traditionelle Dummy-Zellen vorstellbar, d.h. Dummy-Zellen, die als 1-Transistor-Speicherzellen ausgelegt sind.

-IEEE Journal of Solid-State Circuits, Vol. SC-22, No. 5, October 1987, Seiten 651 bis 656, "A 65-ns 4-Mbit CMOS DRAM with a Twisted Driveline Sense Amplifier" und

- 1984 IEEE International Solid-State Circuits Conference, ISSCC 84, February 24, 1984, Seiten 278, 279 und 354 mit dem Titel "A Sub 100ns 256K DRAM in CMOS III Technology". Beide Veröffentlichungen zeigen gattungsgemäße integrierte Halbleiterspeicher ohne Dummy-Zellen.

Bei der Prüfung von integrierten Halbleiterspeichern vom DRAM-Typ wäre es oft erstrebenswert, außer den üblicherweise erfaßbaren Eigenschaften wie Stromaufnahme, Funktionsfähigkeit, Empfindlichkeit auf bestimmte Prüfmuster auch Eigenschaften erfassen zu können, die den Arbeitsbereich verschiedener Teilschaltungen eines Halbleiterspeichers bestimmen (z.B. Zellkapazitäten, Symmetrie von Speicherzellen an Bitleitungen und Referenzbitleitungen, Symmetrie von Bewerterschaltungen). Dies ist bei fertigmontierten Bausteinen bislang nur möglich beispielsweise durch Anlegen von Versorgungspotentialen mit Werten außerhalb des durch eine Spezifikation begrenzten Wertebereiches. Entsprechendes gilt für Pegel von Eingangssignalen. Auf Waferebene ist es bislang zusätzlich möglich, beispielsweise mit Hilfe von sog. Zusatzpads, die nur bei einem noch nicht mit einem Gehäuse versehenen Halbleiterspeicher zugänglich sind, Hilfssignale und/oder Hilfspotentiale zu Analyse- und Testzwecken zuzuführen. Eine weitere Analysemöglichkeit auf Waferebene ist eine gezielte Bestrahlung des Halbleiterspeichers mit Alpha-Partikeln. Alle diese Möglichkeiten stellen jedoch einen ziemlich globalen Einfluß auf den Halbleiterspeicher dar, d.h. es werden meist auch Gebiete außerhalb des Speicherzellenfeldes unerwünscht beeinflußt.

Aufgabe der vorliegenden Erfindung ist es, einen integrierten Halbleiterspeicher zu schaffen, der bei vertretbarem Mehraufwand in Entwicklung und Fertigung Einrichtungen enthält, die ein gezieltes Prüfen und Analysieren eines Zellenfeldes ermöglichen, ohne den Normalbetrieb negativ zu beeinflussen. Es ist auch wünschenswert, daß das Prüfen und Analysieren auch bei einem fertigmontierten Halbleiterspeicher möglich ist. Weiterhin soll auch ein entsprechendes Testverfahren angegeben werden.

Die Aufgabe wird bei einem gattungsgemäßen integrierten Halbleiterspeicher gelöst durch die kennzeichnenden Merkmale der Patentansprüche 1 und 15. Vorteilhafte Aus- und Weiterbildungen sind in Unteransprüchen gekennzeichnet.

Im folgenden wird die Erfindung anhand von FIG näher erläutert.

Es zeigen:

FIG 1 einen Ausschnitt aus einem Halbleiterspeicher nach dem Stande der Technik,

FIG 2 ein Impulsdiagramm zur Anordnung nach FIG 1,

FIG 3, 9, 10 erfindungsgemäße Anordnungen,

FIG 4 ein Impulsdiagramm zur Anordnung nach FIG 3,

FIG 5 bis 8 verschiedene Impulsdiagramme ausschnittsweise und vergrößert dargestellt.

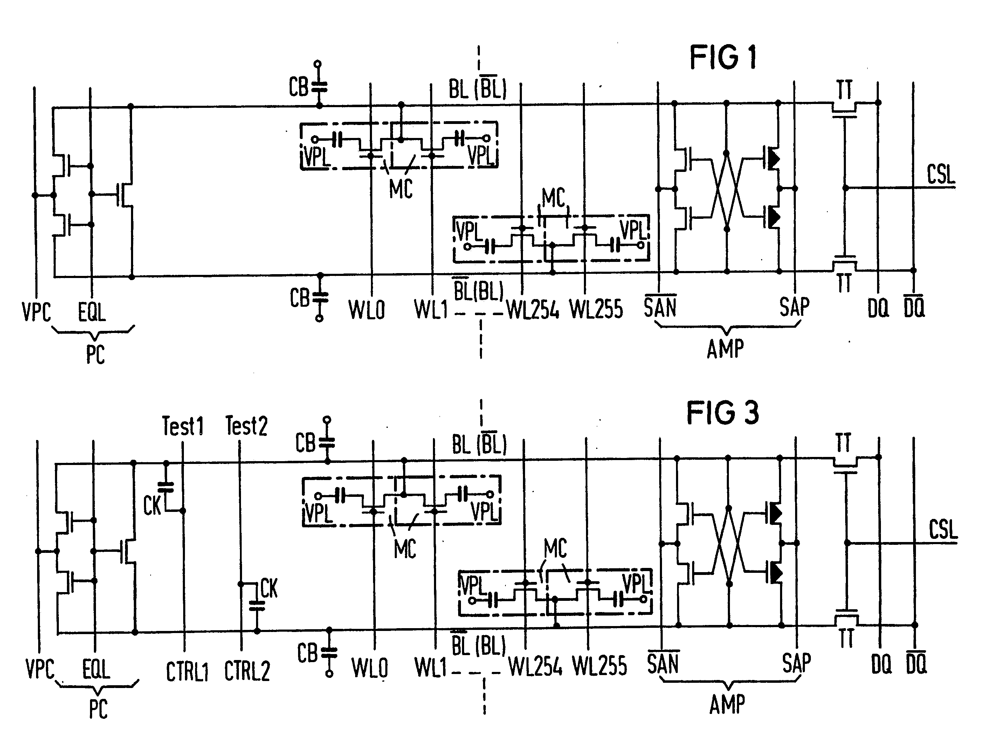

Integrierte Halbleiterspeicher nach dem Stande der Technik enthalten matrixförmig angeordnete, über Wortleitungen und Bitleitungen (als Teil von Bitleitungspaaren) adressierbare Speicherzellen. FIG 1 zeigt ausschnittsweise ein Bitleitungspaar BL, $\overline{BL}$ samt seinen parasitär vorhandenen Bitleitungskapazitäten CB, Speicherzellen MC sowie diesen zugeordnete Wortleitungen WL, die zur Unterscheidung voneinander durchnumeriert sind von 0 (WL0) bis beispielsweise 255 (WL255). Sie zeigt weiterhin eine Precharge-Einrichtung PC. Bekanntlich wird im Betrieb vor Auslesen von Informationen aus einer Speicherzelle MC das Bitleitungspaar BL, $\overline{BL}$ auf ein Precharge-Potential VPC vorgeladen. Dazu wird ein Ausgleichssignal EQL an die Precharge-Einrichtung PC angelegt, wodurch das Precharge-Potential VPC an das Bitleitungspaar BL, $\overline{BL}$ gelangt und dieses auf das Precharge-Potential VPC auflädt. Die Speicherzellen MC sind bei den bekannten Halbleiterspeichern vom Typ DRAM üblicherweise als sog. 1-Transistor-Speicherzellen ausgeführt, die wenigstens einen Speicherkondensator und einen Auswahltransistor enthalten. Die Speicherkondensatoren sind dabei mit ihrem einen Anschluß mit einem sog. Plattenpotential VPL verbunden. Nach dem Vorladen wird zum Auslesen von Informationen aus einer Speicherzelle MC deren Auswahltransistor über eine mit ihm verbundene Wortleitung WL elektrisch leitend geschaltet (= die Speicherzelle MC wird adressiert), wodurch die im Speicherkondensator gespeicherte Ladung als gespeicherte Information auf die der Speicherzelle MC zugeordnete Bitleitung BL des Bitleitungspaares BL, $\overline{BL}$ gelangt. Ein Bitleitungspaar besteht aus zwei Leitungen, der sog. Bitleitung BL und der sog. Referenzbitleitung $\overline{BL}$. Diejenige Leitung, die mit der adressierten Speicherzelle MC verbunden ist, wird als Bitleitung BL bezeichnet. Entsprechend wird diejenige Leitung, die nicht mit der adressierten Speicherzelle MC verbunden ist, sondern mit anderen Speicherzellen MC desselben Bitleitungspaares, als Referenzbitleitung $\overline{BL}$ bezeichnet. Soll beispielsweise eine der Speicherzellen MC ausgelesen werden, die mit einer der Wortleitungen WL0,WL1 verbunden sind, so werden die in FIG 1 oben liegende Leitung als Bitleitung BL bezeichnet und die in FIG 1 unten liegende Leitung als Referenzbitleitung $\overline{BL}$ bezeichnet. Soll jedoch beispielsweise eine der Speicherzellen MC ausgelesen werden, die mit einer der Wortleitungen WL254,WL255 verbunden sind, so werden die in FIG 1 unten liegende Leitung als Bitleitung BL bezeichnet (in FIG 1 in Klammern gesetzt) und die in FIG 1 oben liegende Leitung als Referenzbitleitung $\overline{BL}$ bezeichnet (in FIG 1 ebenfalls in Klammern gesetzt). Zum einfacheren Verständnis wird nachfolgend zugrunde gelegt, daß aus der mit der Wortleitung WL0 verbundenen Speicherzelle MC auszulesen ist. Wegen der Allgemeingültigkeit dieser Beschreibung wird anstelle des Bezugszeichens WL0 künftig allgemein das Bezugszeichen WL verwendet.

Die auf der Bitleitung BL nach dem Auslesen anliegende Information, künftig "das Lesesignal" genannt, wird anschließend mittels einer Bewerterschaltung AMP bewertet und verstärkt. Dadurch nimmt das Lesesignal den ihm zugeordneten logischen Pegel ("0" oder "1") an. Entsprechend bildet sich auf der Referenzbitleitung $\overline{BL}$ ein dazu komplementäres Signal aus mit einem entsprechenden komplementären logischen Pegel ("1" oder "0"). Moderne Bewerterschaltungen AMP sind meist als zwei parallelgeschaltete dynamische Flip-Flops aus jeweils kreuzgekoppelten Transistoren gestaltet. Das eine Flip-Flop enthält dabei im allgemeinen Transistoren vom n-Kanal-Typ; das andere Flip-Flop solche vom p-Kanal-Typ. Die Flip-Flops werden in diesem Falle durch zwei Taktsignale SAP und $\overline{SAN}$ gesteuert. Dies ermöglicht ein schnelles Ansprechen der Bewerterschaltung AMP sowie anschließend daran ein Zurückschreiben der ausgelesenen und ver stärkten Informationen in die ausgelesene Speicherzelle MC mit vollwertigen logischen Pegeln. Über durch einen Dekoder (nicht dargestellt) gesteuerte Transfertransistoren TT gelangt die bewertete und verstärkte Information an Datenausgangsleitungen DQ, $\overline{DQ}$.

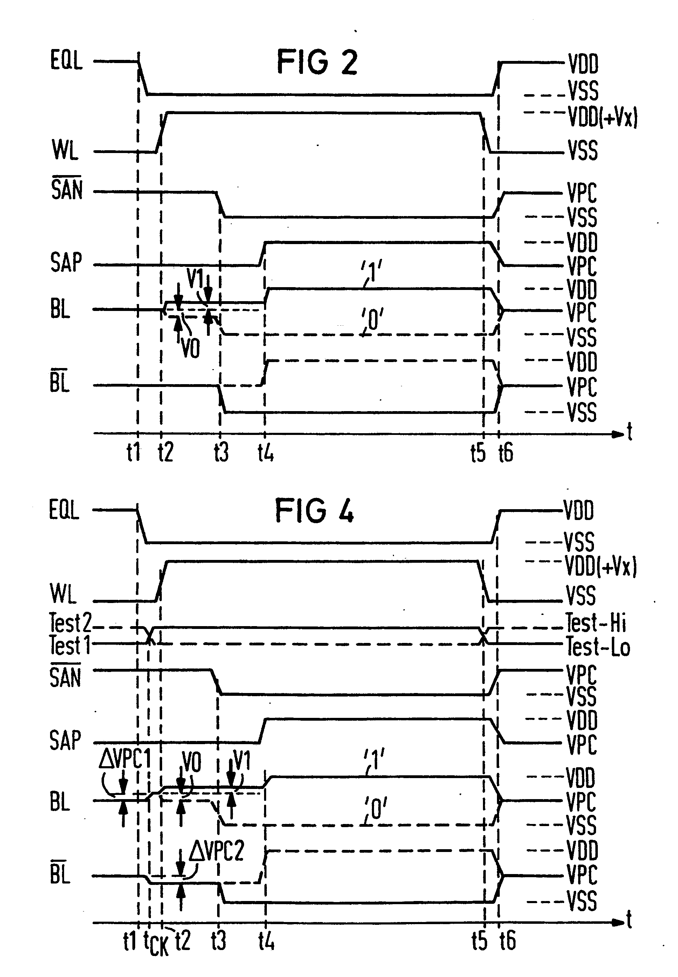

Der Ablauf des gesamten Vorganges ist in FIG 2 in Form eines Impulsdiagrammes dargestellt: Vor Beginn des beschriebenen Lese- und Bewertevorganges ist das Ausgleichssignal EQL aktiv zur Durchführung des Vorladevorganges; alle anderen Signale sind inaktiv. Dadurch nehmen die Bitleitung BL und die Referenzbitleitung $\overline{BL}$ das Precharge-Potential VPC an. Zu einem Zeitpunkt t1, der nach einer Übernahme und Dekodierung von an den Halbleiterspeicher anzulegenden Adressen liegt, wird das Ausgleichssignal EQL inaktiv geschaltet; der Vorladevorgang ist beendet. Zu einem Zeitpunkt t2 wird die Wortleitung WL aktiviert. Dadurch wird die in der adressierten Speicherzelle MC gespeicherte Information auf die Bitleitung BL ausgelesen. Entspricht die ausgelesene Information einer log. 1, so wird durch das Auslesen das auf der Bitleitung BL liegende (Precharge-)Potential VPC um einen dem Lesesignal entsprechenden Betrag V1 erhöht. Entspricht die ausgelesene Information jedoch einer log. 0, so wird durch das Auslesen das auf der Bitleitung BL liegende (Precharge-)Potential VPC um einen dem Lesesignal entsprechenden Betrag V0 erniedrigt. Diese Phase ist in FIG 2 folgendermaßen dargestellt: Der Wert des Precharge-Potentials VPC ist punktiert eingezeichnet ab dem Zeitpunkt t2. Der um den Betrag V1 erhöhte Potentialwert der Bitleitung BL ist mit einer voll durchgezogenen Linie dargestellt ab dem Zeitpunkt t2. Der um den Betrag V0 erniedrigte Potentialwert der Bitleitung BL ist gestrichelt dargestellt ab dem Zeitpunkt t2.

Zu einem Zeitpunkt t3 wird das eine Taktsignal $\overline{SAN}$ aktiviert. Bis zu diesem Zeitpunkt weist die Referenzbitleitung $\overline{BL}$ auf jeden Fall ihr Precharge-Potential VPC auf. Ist die Bitleitung BL zum Zeitpunkt t3 auf den um den Betrag V1 erhöhten Potential, so nimmt die Referenzbitleitung $\overline{BL}$ jetzt den Wert log. 0 an (mit einer voll durchgezogenen Linie dargestellt), wohingegen die Bitleitung BL unverändert bleibt. Ist die Bitleitung BL zum Zeitpunkt t3 jedoch auf dem um den Betrag V0 erniedrigten Potential, so nimmt die Bitleitung BL den Wert log. 0 an, während die Referenzbitleitung $\overline{BL}$ unverändert ihr Precharge-Potential VPC beibehält (gestrichelt dargestellt). Dies ist eine erste Phase des Bewerte- und Verstärkungsvorganges.

Daran schließt sich zu einem Zeitpunkt t4 eine zweite Phase an: Zum Zeitpunkt t4 wird das andere Taktsignal SAP aktiviert. Liegt zu diesem Zeitpunkt die Bitleitung BL auf dem um den Betrag V1 erhöhten Potential, so nimmt die Bitleitung BL nunmehr den Wert log. 1 an; die Referenzbitleitung $\overline{BL}$ bleibt unverändert auf log. 0. Liegt die Bitleitung BL jedoch bereits auf log. 0, so nimmt die Referenzbitleitung $\overline{BL}$ den Wert log. 1 an.

In einem späteren Zeitpunkt t5 wird die Wortleitung WL wieder deaktiviert. Anschließend (Zeitpunkt t6) werden die Taktsignale $\overline{SAN}$ und SAP deaktiviert und das Ausgleichssignal EQL aktiviert. Die Bitleitung BL

und die Referenzbitleitung $\overline{BL}$ nehmen demzufolge wieder das Precharge-Potential VPC an. Der Einfachheit halber werden in FIG 2 (und auch in den nachfolgend noch zu beschreibenden wieteren Impulsdiagrammen) der Wert "log. 1" potentialmäßig gleichgesetzt mit einem ersten Versorgungspotential VDD und der Wert "log. 0" potentialmäßig gleichgesetzt einem zweiten Versorgungspotential VSS des Halbleiterspeichers. Dies ist jedoch nur beispielhaft; andere Potentialwerte sind möglich. Die Taktsignal $\overline{SAN}$, SAP weisen im inaktiven Zustand das Precharge-Potential VPC auf und im aktiven Zustand die Werte log. 0 bzw. log. 1.

Nach FIG 3 weist der integrierte Halbleiterspeicher erfindungsgemäß je Bitleitung BL und Referenzbitleitung $\overline{BL}$ eine Koppelkapazität CK auf. Der erste Anschluß jeder Koppelkapazität CK ist mit der Bitleitung BL bzw. mit der Referenzbitleitung $\overline{BL}$ verbunden. Die zweiten Anschlüsse der Koppelkapazität CK sind mit einem Paar von Steuerleitungen CTRL1,CTRL2 verbunden. Damit lassen sich im Betrieb (hierbei ist insbesondere ein Testbetrieb des Halbleiterspeichers vorgesehen) zusätzliche Potentiale $\Delta$VPC1, $\Delta$VPC2 auf das Bitleitungspaar Bl, $\overline{BL}$ einkoppeln, was je nach Ausgestaltung eines Paares von Testsignalen Test1,Test2, mit dem die Steuerleitungen CTRL1,CTRL2 beaufschlagbar sind, zu unterschiedlichen Veränderungen der Potentiale auf der Bitleitung BL und auf der Referenzbitleitung $\overline{BL}$ um die genannten zusätzlichen Potentiale $\Delta$VPC1, $\Delta$VPC2 führt. Nach Ausführen des Einkoppelvorganges unterscheiden sich somit die Potentiale von Bitleitung BL und Referenzbitleitung $\overline{BL}$ um die (mathematisch betrachtet) Differenz der Werte der zusätzlichen Potentiale $\Delta$VPC1, $\Delta$VPC2. Wirkungsweise und Sinn dieser Anordung werden nachstehend anhand von Impulsdiagrammen (FIG 4 bis 8) erläutert.

Den Diagrammen sind folgende Vereinfachungen zugrunde gelegt, die zwar zur Ausführung der Erfindung nicht nötig sind, die die Übersichtlichkeit der Darstellung jedoch erleichtern: Die Testsignale Test1,Test2 weisen gleiche High-Pegel-Werte Test-Hi und gleiche Low-Pegel-Werte Test-Lo auf. Sie wechseln ihre Pegel gleichzeitig zu einem Zeitpunkt $t_{CK}$. Weiterhin haben sie zueinander invertierte Pegel.

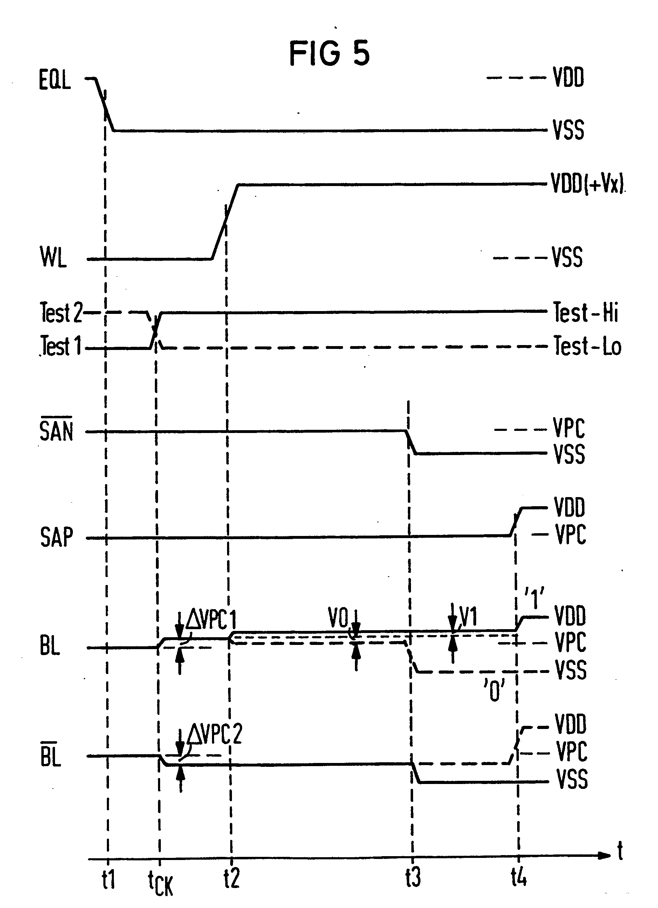

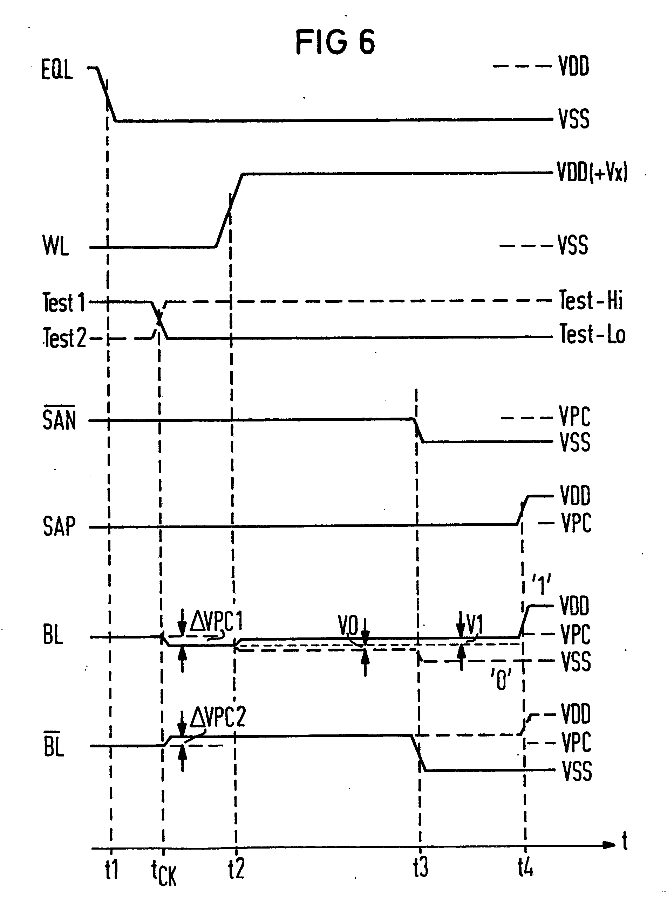

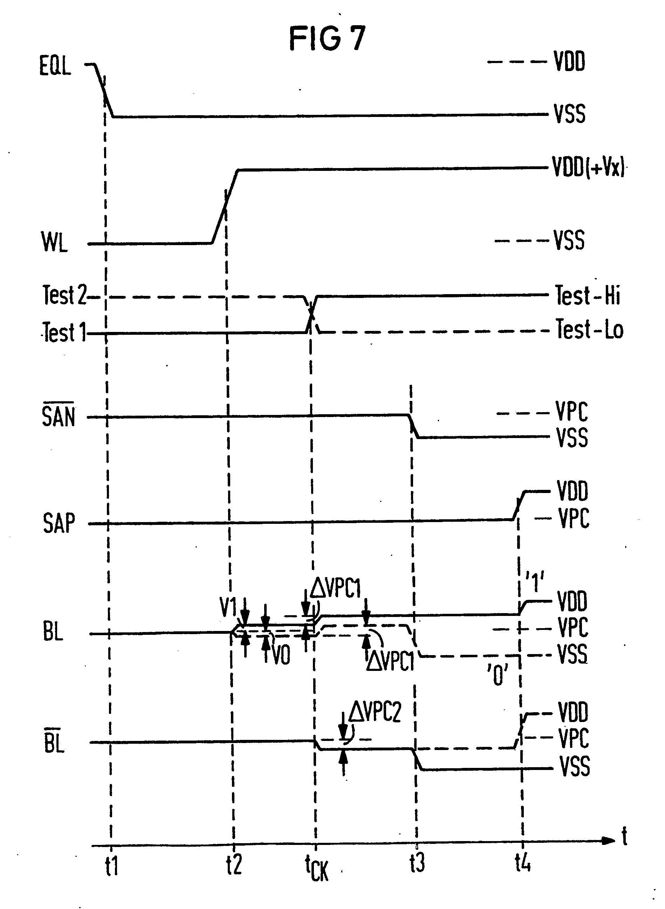

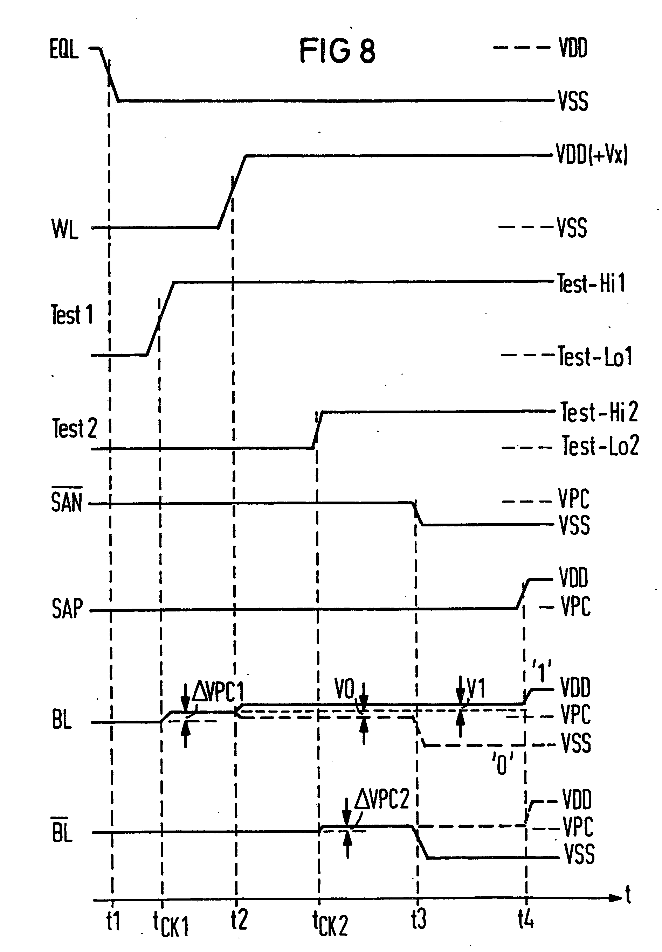

FIG 4 zeigt das Impulsdiagramm nach FIG 2, ergänzt um die Testsignale Test1,Test2. FIG 4 zeigt ferner die Auswirkungen des Paares von Testsignalen Test1,Test2 auf das Bitleitungspaar BL, $\overline{BL}$. Das eine Testsignal Test1 bewirkt mittels eines Flankenwechsels zum Zeitpunkt $t_{CK}$ das Einkoppeln des einen zusätzlichen Potentials $\Delta$VPC1 auf die Bitleitung BL. Entsprechend bewirkt das andere Testsignal Test2 mittels eines Flankenwechsels zum selben Zeitpunkt $t_{CK}$ (aus obengenannten Gründen so gewählt) das Einkoppeln des anderen zusätzlichen Potentials $\Delta$VPC2 auf die Referenzbitleitung $\overline{BL}$. Wegen des (der Einfachheit halber angenommenen) gegensinnigen zeitlichen Verlaufes und wegen der gleichen Pegelwerte Test-Hi,Test-Lo der beiden Teilsignale Test1,Test2 haben die zusätzlichen Potentiale $\Delta$VPC1,$\Delta$VPC2 zwar betragsmäßig gleiche Werte, jedoch mit verschiedenen Vorzeichen. Die Flankenwechsel finden frühestens mit Beenden des Vorladevorganges (Zeitpunkt t1) und spätestens vor Beginn des Bewerte- und Verstärkungsvorganges (Zeitpunkt t3) statt. Es ist jedoch durchaus zulässig, daß die Flankenwechsel der beiden Testsignale Test1,Test2 innerhalb des genannten Zeitraumes (t1 bis t3) zu verschiedenen Zeitpunkten $t_{CK1},t_{CK2}$ stattfinden. Zur Verdeutlichung des gesamten Vorganges ist der Zeitraum zwischen den Zeitpunkten kurz vor t1 und kurz nach t4 in den FIG 5 bis 8 vergrößert dargestellt. Die FIG 5 und 7 zeigen einen positiven Flankenwechsel des einen Testsignals Test1 und einen entsprechenden negativen Flankenwechsel des anderen Testsignals Test2. FIG 6 zeigt einen negativen Flankenwechsel des einen Testsignals Test1 sowie einen positiven Flankenwechsel des anderen Testsignals Test2. Weiterhin liegt der Zeitpunkt $t_{CK}$ der Flankenwechsel bei den FIG 5 und 6 zwischen den Zeitpunkten t1 und t2; in FIG 7 liegt er zwischen den Zeitpunkten t2 und t3. FIG 8 zeigt weitere Ausgestaltungsmöglichkeiten der Testsignale Test1,Test2. Zunächst wird FIG 4 in Verbindung mit FIG 5 näher erläutert:

Bis zum Zeitpunkt t1 besteht kein Unterschied zwischen den Impulsdiagrammen nach den FIG 2 und 4, abgesehen von den beiden Testsignalen Test1 und Test2. Das eine Testsignal Test1 weist einen ersten Pegel auf. Nach den FIG 4 und 5 sei dies der Low-Pegel Test-Lo (dargestellt mit einer voll durchgezogenen Linie). Entsprechend weist das andere Testsignal Test2 einen zweiten Pegel auf. Nach den FIG 4 und 5 sei dies der High-Pegel Test-Hi (gestrichelt dargestellt). Zum Zeitpunkt $t_{CK}$ finden die genannten Flankenwechsel statt: Das eine Testsignal Test1 nimmt einen zweiten Pegel an, im Beispeil den High-Pegel Test-Hi und das andere Testsignal Test2 nimmt den ersten Pegel an, im Beispiel den Low-Pegel Test-Lo. Dadurch werden über die Koppelkapazitäten CK auf die Bitleitung BL und auf die Referenzbitleitung $\overline{BL}$ die zusätzlichen Potentiale $\Delta$VPC1 und $\Delta$VPC2 eingekoppelt. Sie weisen (lediglich aufgrund des gewählten Beispiels) zwar betragsmäßig gleiche Werte, jedoch mit zueinander entgegengesetzten Vorzeichen auf. Dadurch nimmt die Bitleitung BL ein um das eine zusätzliche Potential $\Delta$VPC1 erhöhtes Potential an, während die Referenzbitleitung $\overline{BL}$ ein um das andere zusätzliche Potential $\Delta$VPC2 erniedrigtes Potential annimmt. Zwischen dem Bitleitungspaar BL, $\overline{BL}$ bildet sich also eine Offsetspannung $\Delta$VPC1 - $\Delta$VPC2 aus. Beim nachfolgenden Aktivieren der Wortleitung WL wirkt sich der entsprechende Betrag V1 (bzw. V0), der dem Lesesignal entspricht, auf das um das eine zusätzliche Potential $\Delta$VPC1 erhöhte Gesamtpotential der

4

Bitleitung BL aus und hebt dieses entsprechend weiter an um den Betrag V1 (bzw. verringert es den Betrag V0). Auf die Referenzbitleitung $\overline{BL}$ wirkt sich das Lesesignal nicht aus, analog zur Darstellung nach FIG 2, wodurch die Referenzbitleitung $\overline{BL}$ ihr um das andere zusätzliche Potential ΔVPC2 erniedrigte Potential beibehält. Zu den Zeitpunkten t3 und t4 werden dann, wie bereits in FIG 2 erläutert, die Taktsignale $\overline{SAN}$ und SAP aktiviert, was den Bewerte- und Verstärkungsvorgang mittels der Bewerterschaltung AMP bewirkt. Spätestens zum Zeitpunkt t6 (beispielsweise zum Zeitpunkt t5) nehmen die Testsignale Test1,Test2 wieder ihren ursprünglichen Zustand an.

Beim Impulsdiagramm nach FIG 5, wie vorstehend beschrieben, weist das eine Testsignal Test1 zum Zeitpunkt $t_{CK}$ einen positiven Flankenwechsel auf ("positive going"). Beim Impulsdiagramm nach FIG 6 hingegen weist das eine Testsignal Test1 zum Zeitpunkt $t_{CK}$ einen negativen Flankenwechsel auf ("negative going"). Weiterhin weist in FIG 6 das andere Testsignal Test2 einen positiven Flankenwechsel auf. Demzufolge werden das Precharge-Potential VPC der Bitleitung BL um dem Betrag ΔVPC1 erniedrigt und das Precharge-Potential VPC der Referenzbitleitung $\overline{BL}$ um den Betrag ΔVPC2 erhöht. Der weitere Verlauf ist analog zum bereits beschrieben Verlauf nach FIG 5.

Das Impulsdiagramm nach FIG 7 weist zwar wiederum einen positiven Flankenwechsel des einen Testsignals Test1 auf und einen negativen Flankenwechsel des anderen Testsignals Test2 (vgl. FIG 5); der Zeitpunkt $t_{CK}$ der Flankenwechsel liegt jedoch zwischen den Zeitpunkten t2 und t3. Dies hat zwar zur Folge, daß zum Zeitpunkt $t_{CK}$ des Einkoppelns der zusätzlichen Potentiale ΔVPC1,ΔVPC2 auf das Bitleitungspaar BL, $\overline{BL}$ die Bitleitung BL bereits ein Potential aufweist, das gegenüber dem Precharge-Potential VPC um das Lesesignal V1 bzw. V0 angehoben bzw. abgesenkt ist. Vergleichen mit dem Impulsdiagramm nach FIG 5 hat dies jedoch auf die Bewertung und Verstärkung, d.h. auf die Vorgänge ab dem Zeitpunkt t3, keinerlei unterschiedlichen Einfluß, da zum Zeitpunkt t3 sowohl die Bitleitung BL wie auch die Referenzbitleitung $\overline{BL}$ bei beiden FIG 5 und 7 (gleiche Lesesignale V1 bzw. V0 und gleiche Precharge-Potentiale VPC vorausgesetzt) jeweils dasselbe Gesamtpotential VPC + V1 (bzw. -V0) + ΔVPC1 (Bitleitung BL) bzw. VPC - |ΔVPC2| (Referenzbitleitung $\overline{BL}$) aufweisen.

In Weiterbildung der Erfindung ist es vorteilhaft, daß die High-pegel Test-Hi der Testsignale Test1,Test2 variabel vorwählbare Werte sind. Ebenso ist es vorteilhaft, daß die Low-Pegel Test-Lo der Testsignale Test1,Test2 variabel vorwählbare Werte sind. Der Vorteil liegt darin, daß mittels der variabel vorwählbaren Werte der High-Pegel Test-Hi und/oder der Low-Pegel Test-Lo die zusätzlichen Potentiale ΔVPC1,ΔVPC2 betragsmäßig variierbar sind.

Weiterhin ist es vorteilhaft, daß die das Einkoppeln bestimmenden Flanken des Paares von Testsignalen Test1,Test2 sowohl eine positive wie auch eine negative Flanke des einen Testsignals Test1 und entsprechend sowohl eine negative wie auch eine positive Flanke des anderen Testsignals Test2 sein können, da sich dadurch die Potentiale der Bitleitung BL und der Referenzbitleitung $\overline{BL}$ in jedem Fall gegenläufig verändern.

Vorteilhaft ist es weiterhin (s. FIG 8), wenn die High-Pegel Test-Hi1,Test-Hi2 der Testsignale Test1,Test2 verschieden von einander sind. Ebenso ist es vorteilhaft, wenn die Low-Pegel Test-Lo1,Test-Lo2 der Testsignale Test1,Test2 verschieden voneinander sind.

In den vorstehenden Beispielen ist beschrieben, daß die Flankenwechsel der Testsignale Test1,Test2 gleichzeitig zum Zeitpunkt $t_{CK}$ erfolgen. Es ist jedoch im Rahmen der vorliegenden Erfindung gemäß FIG 8 auch günstig, wenn die Flankenwechsel zu verschiedenen Zeitpunkten $t_{CK1},t_{CK2}$ erfolgen. Es besteht lediglich die bereits genannte Einschränkung, daß die Flankenwechsel innerhalb des Zeitraumes zwischen den Zeitpunkten t1 und t3 erfolgen müssen.

Weiterhin wurde in den vorstehenden Beispielen beschrieben, daß die Testsignale Test1,Test2 einen zeitlich gegensinnigen Verlauf zueinander haben. In einer weiteren Ausführungsform der Erfindung, dargestellt ebenfalls in FIG 8, haben die Testsignale Test1,Test2 einen zeitlich gleichsinnigen Verlauf. Dabei ist jedoch zu beachten, daß die Differenz zwischen dem High-Pegel Test-Hi1 des einen Testsignals Test1 und seinem Low-Pegel Test-Lo1 unterschiedlich ist zur Differenz zwischen dem High-Pegel Test-Hi2 des anderen Testsignals Test2 und dessen Low-Pegel Test-Lo2.

Weiterhin ist es vorteilhaft, daß das Paar von Steuerleitungen CTRL1,CTRL2 beispielsweise im Normalbetrieb elektrisch floatend geschaltet ist, d.h. nicht mit dem Paar von Testsignalen Test1,Test2 verbunden ist oder daß es im Normalbetrieb mit einem festen Potential verbunden ist. Dies gewährleistet einen von den Testsignalen Test1,Test2 unabhängigen Betrieb des Halbleiterspeichers; d.h. es findet kein Einkoppeln der zusätzlichen Potentiale ΔVPC1,ΔVPC2 statt. Das Ankoppeln der Testsignale Test1,Test2 an die Steuerleitungen CTRL1,CTRL2 bzw. deren Abkoppeln läßt sich beispielsweise durch die bekannte Impulsfolge " $\overline{CAS}$-before-$\overline{RAS}$ " als Steuerungsmittel erreichen (s. dazu die bereits angegebene Literatur "IEEE Journal of Solid-State Circuits, Vol. SC-22" speziell Abschnitt III). Der " $\overline{CAS}$-before-$\overline{RAS}$ "-Betrieb zum Durchführen irgendwelcher Tests in einem integrierten Halbleiterspeicher ist ein dem Fachmann mittlerweile selbstverständliches Hilfsmittel.

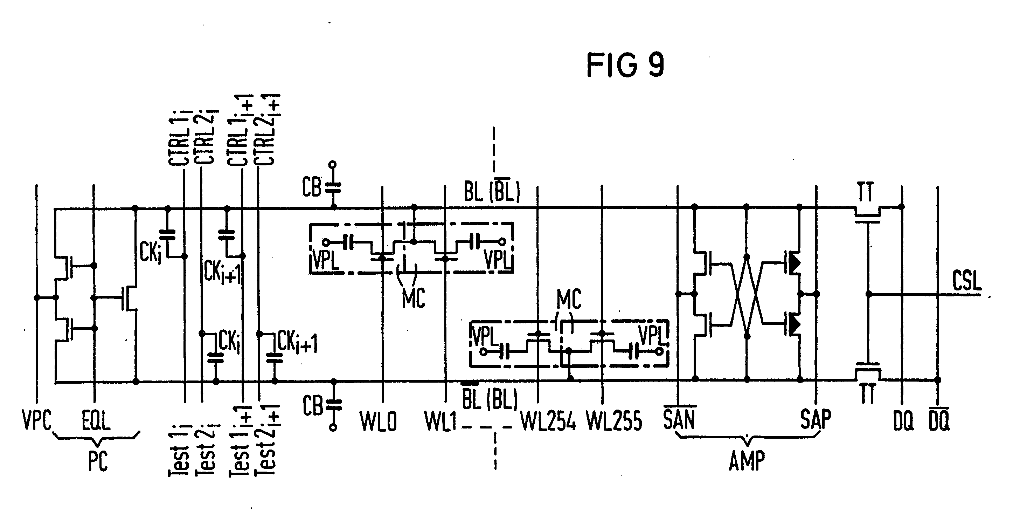

Gemäß der Darstellung nach FIG 9 ist es weiterhin vorteilhaft, anstelle oder zusätzlich zu den Koppelkapazitäten CK samt zugehörigem Steuerleitungspaar CTRL1,CTRL2 je Bitleitungspaar BL, $\overline{BL}$ mehrere Koppelkapazitäten $CK_i$ je Bitleitung BL und Referenzbitleitung $\overline{BL}$ vorzusehen mit Paaren von Steuerleitungen $CTRL1_i,CTRL2_i$, die unabhängig voneinander mit Paaren von Testsignalen $Test1_i,Test2_i$ verbindbar sind im Betrieb. Die Paare von Testsignalen $Test1_i,Test2_i$ haben in einer ersten Ausführungsform fest vorgegebenen High- bzw. Low-Pegel Test-Hi,Test-Lo. In Weiterbildung sind jedoch auch variabel vorwählbare Pegel vorsehbar. Die Vorwahl der High- und Low-Pegel des Paares bzw. der Paare von Testsignalen Test1,Test2 bzw. $Test1_i,Test2_i$ erfolgt der Einfachheit halber über den genannten " $\overline{CAS}$ -before-$\overline{RAS}$ "-Betrieb mit Hilfe einer einfachen Auswahlschaltung, durch Abgriff von einer Widerstandskette o.ä. Vorteilhafterweise sind dabei die Paare von Testsignalen $Test1_i,Test2_i$ auch einzeln schaltbar.

Der Einsatz mehrerer Koppelkapazitäten $CK_i$ anstelle bzw. zusätzlich zu einer einzigen Koppelkapazität CK je Bitleitung BL und Referenzbitleitung $\overline{BL}$ ermöglicht ebenso wie die variable Wählbarkeit von High- und/oder Low-Pegel Test-Hi,Test-Lo des Paares bzw. der Paare von Testsignalen Test1,Test2 bzw. $Test1_i,Test2_i$ eine Variation der Werte der zusätzlichen Potentiale $\Delta$VPC1,$\Delta$VPC2. Der Wert des zusätzlichen Potentials $\Delta$VPC1 bzw. $\Delta$VPC2 ist je Testsignal Test1 bzw. Test2 nach folgender Formel bestimmbar:

$$\Delta\text{VPC1}, \ \Delta\text{VPC2} = (\text{Test-Hi} - \text{Test-Lo}) \cdot \frac{CK}{CK + CB} \ ,$$

wobei CB den Wert der Kapazität einer Bitleitung BL bzw. einer Referenzbitleitung $\overline{BL}$ darstellt und die restlichen Operanden den Wert darstellen, den die unter dem gleichen Bezugszeichen beschriebenen Elemente aufweisen.

Betragen beispielsweise das erste Versorgungspotential VDD = 5 V, das zweite Versorgungspotential VSS = 0 V und der Betrag eines typischen Lesesignals V1 (bzw. V0) = 50 mV, so ist es günstig, in verschiedenen Testzyklen die Werte der zusätzlichen Potentiale $\Delta$VPC1, $\Delta$VPC2 von beispielsweise 2 mV bis 50 mV in Stufen von beispielsweise 2 bis 5 mV festzulegen.

Wichtige Vorteile der vorliegenden Erfindung sind:
- Analysemöglichkeit von Empfindlichkeit, Geschwindigkeit und Symmetrieverhalten (bezüglich Unterscheidbarkeit von log. 0 gegenüber log. 1 beim Lesesignal) der Bewerter- und Verstärkerschaltungen AMP sowie der Speicherzellen MC durch Variation der Precharge-Potentiale VPC mittels der zusätzlichen Potentiale $\Delta$VPC1, $\Delta$VPC2;
- Analysemöglichkeit hinsichtlich der Größe und der Veränderung der Lesesignele V1,V0 und der Werte der Speicherkapazitäten der Speicherzellen MC in Abhängigkeit von den zusätzlichen Potentialen $\Delta$VPC1, $\Delta$VPC2 über nachfolgende Formel:
$\Delta$V1, $\Delta$V0 = $\Delta$VPC1 - $\Delta$VPC2,
wobei $\Delta$V1 und $\Delta$V0 die auftretende Änderung des Lesesignals in Abhängigkeit von der Änderung der zusätzlichen Potentiale $\Delta$VPC1, $\Delta$VPC2 bedeuten beim Auslesen von Informationen, die einer log. 1 bzw. einer log. 0 entsprechend.

Die vorliegende Erfindung wurde anhand eines integrierten Halbleiterspeichers erläutert, der keine sog. Dummy-Zellen aufweist. Sie ist jedoch ebenfalls anwendbar auf integrierte Halbleiterspeicher, die diese Dummy-Zellen aufweisen.

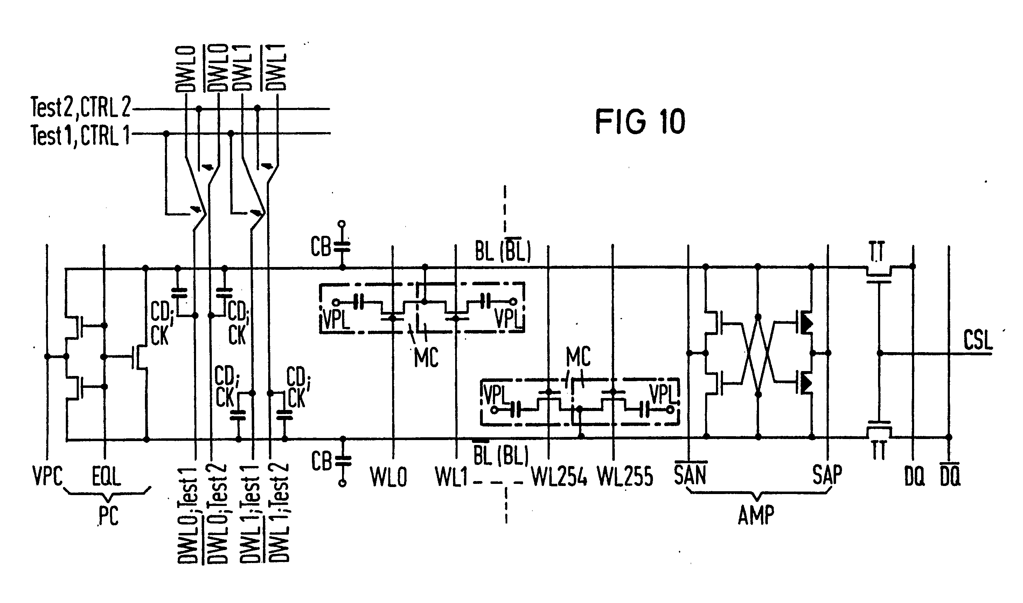

Spezielle Dummy-Zellen sind beispielsweise in Form von "Complementary Capacitor-Coupled Dummy-Cell" (vgl. bereits angegebene Literaturstelle "IEEE Journal of Solid-State Circuits, Vol. SC-20", insbesondere FIG2 und 3) bekannt. FIG 10 zeigt eine vorteilhafte, spezielle Anwendung der vorliegenden Erfindung auf solche Kompensationszellen. Die Kapazitäten CD der Kompensationszellen liegen dabei einseitig auf einem festen Potential. Im Testfall werden nicht, wie im Normalfall üblich, eine einzige Kompensationszelle des Bitleitungspaares BL, $\overline{BL}$ mittels einer als Dummy-Wortleitung DWL (bzw. $\overline{DWL}$) wirkenden Leitung angesteuert, sondern es werden die Kapazitäten CD aller Klompensationszellen eines Bitleitungspaares BL, $\overline{BL}$ über das Paar von Testsignalen Test1,Test2 der vorbeschriebenen Art führende, gemeinsam als Paar von Steuerleitungen CTRL1,CTRL2 wirkende Leitungen angesteuert. Dadurch bilden sich die zusätzlichen Potentiale $\Delta$VPC1, $\Delta$VPC2 auf Bitleitung BL und Referenzbitleitung $\overline{BL}$ aus in Abhängigkeit von den Werten der Testsignale Test1,Test2. Die zusätzlichen Potentiale $\Delta$VPC1,$\Delta$VPC2 sind wertemäßig von den Testsignalen Test1,Test2 bestimmt.

Vorteilhaft dabei ist es, daß die vorhandenen Kompensationszellen durch Beschalten mit dem Paar von Testsignalen Test1,Test2 im Testfall die Funktion der Koppelkapazitäten CK übernehmen können unter Aufgabe ihrer Funktion als Kompensationszellen. Im Testfall weist der integrierte Halbleiterspeicher demzufolge keine Kompensationszellen auf, sondern Koppelkapazitäten CK im Sinne der vorliegenden Erfindung. Diese Doppelfunktion ermöglicht einen minimalen Flächenbedarf für die vorliegende Erfindung.

**Ansprüche**

1. Integrierter Halbleiterspeicher vom Typ DRAM mit Wortleitungen (WL), mit Bitleitungspaaren (BL, $\overline{BL}$), mit matrixförmig angeordneten Speicherzellen (MC) und mit einer Bewerterschaltung (AMPL) je Bitleitungspaar (BL, $\overline{BL}$), bei dem jedes Bitleitungspaar (BL, $\overline{BL}$) im Betrieb in eine Bitleitung (BL) und in eine Referenzbitleitung ($\overline{BL}$) eingeteilt ist, **dadurch gekennzeichnet,** daß jede Bitleitung (BL) und jede Referenzbitleitung ($\overline{BL}$) wenigstens eine Koppelkapazität (CK;CKi) aufweisen, deren erste Anschlüsse mit dem Bitleitungspaar (BL, $\overline{BL}$) verbunden sind und deren zweite Anschlüsse mit je einer Steuerleitung (CTRL1,CTRL2;CTRL1$_i$,CTRL2$_i$) eines Paares von Steuerleitungen (CTRL1,CTRL2;CTRL1$_i$,CTRL2$_i$) verbunden sind.

2. Integrierter Halbleiterspeicher nach Anspruch 1, **dadurch gekennzeichnet,** daß die Steuerleitungen (CTRL1,CTRL2;CTRL1$_i$,CTRL2$_i$) in einem Normalbetrieb ein festes Potential aufweisen.

3. Integrierter Halbleiterspeicher nach Anspruch 1, **dadurch gekennzeichnet,** daß die Steuerleitungen (CTRL1,CTRL2;CTRL1$_i$,CTRL2$_i$) in einem Normalbetrieb einen elektrisch floatenden Zustand aufweisen.

4. Integrierter Halbleiterspeicher nach einem der vorhergehenden Ansprüche, **dadurch gekennzeichnet,** daß jedes Paar von Steuerleitungen (CTRL1,CTRL2) in einem Testbetrieb ein Paar von zueinander unterschiedlichen Testsignalen (Test1,Test2) führt.

5. Integrierter Halbleiterspeicher nach Anspruch 4, **dadurch gekennzeichnet,** daß die High-Pegel (Test-Hi) der Testsignale (Test1,Test2) vorwählbar sind.

6. Integrierter Halbleiterspeicher nach Anspruch 4 oder 5, **dadurch gekennzeichnet,** daß die Low-Pegel (Test-Lo) der Testsignale (Test1,Test2) vorwählbar sind.

7. Integrierter Halbleiterspeicher nach einem der Ansprüche 4 bis 6, **dadurch gekennzeichnet,** daß die High-Pegel (Test-Hi1,Test-Hi2) der Testsignale (Test1,Test2) verschieden voneinander sind.

8. Integrierter Halbleiterspeicher nach einem der Ansprüche 4 bis 7, **dadurch gekennzeichnet,** daß die Low-Pegel (Test-Lo1,Test-Lo2) der Testsignale (Test1,Test2) verschieden voneinander sind.

9. Integrierter Halbleiterspeicher nach einem der Ansprüche 4 bis 8, **dadurch gekennzeichnet,** daß eine der Steuerleitungen (CTRL1,CTRL2) im Testbetrieb ein festes Potential aufweist.

10. Integrierter Halbleiterspeicher nach einem der Ansprüche 4 bis 8, **dadurch gekennzeichnet,** daß eine der Steuerleitungen (CTRL1,CTRL2) im Testbetrieb einen elektrisch floatenden Zustand aufweist.

11. Integrierter Halbleiterspeicher nach einem der Ansprüche 4 bis 10, **dadurch gekennzeichnet,** daß bei Vorhandensein von mehr als einem Paar von Steuerleitungen (CTRL1$_i$,CTRL2$_i$) wenigstens eines der Paare von Steuerleitungen im Testbetrieb ein festes Potential aufweist.

12. Integrierter Halbleiterspeicher nach einem der Ansprüche 4 bis 11, **dadurch gekennzeichnet,** daß bei Vorhandensein von mehr als einem Paar von Steuerleitungen (CTRL1$_i$,CTRL2$_i$) wenigstens eines der Paare von Steuerleitungen im Testbetrieb einen elektrisch floatenden Zustand aufweist.

13. Integrierter Halbleiterspeicher nach einem der Ansprüche 4 bis 12, **dadurch gekennzeichnet,** daß in dem Fall, in dem jede Bitleitung (BL) und jede Referenzbitleitung ($\overline{BL}$) mehr als eine Koppelkapazität (CK$_i$) mit Steuerleitungen (CTRL1$_i$,CTRL2$_i$) aufweisen, im Betrieb die zugeordneten Paare von Testsignalen (Test1$_i$,Test2$_i$) unabhängig voneinander aktivierbar sind.

14. Integrierter Halbleiterspeicher nach einem der vorhergehenden Ansprüche und mit Dummy-Zellen (CD), **dadurch gekennzeichnet,** daß im Testbetrieb die Dummy-Zellen (CD) als Koppelkapazitäten (CK) verwendet werden und daß anstelle einer Ansteuerung mit Dummy-Wortleitungen (DWL, $\overline{DWL}$;DWL0, $\overline{DWL0}$,DWL1, $\overline{DWL1}$) eine Ansteuerung mit wenigstens einem Paar von Testsignalen (Test1,Test2;Test1$_i$,Test2$_i$) erfolgt, so daß die Funktion als Dummy-Zelle verloren geht.

15. Verfahren zum Testen eines integrierten Halbleiterspeichers vom Typ DRAM, bei dem in Speicherzellen (MC) gespeicherte Daten aus den Speicherzellen (MC) ausgelesen werden und bei dem Bitleitungen (BL) und Referenzbitleitunge ($\overline{BL}$) vor dem Auslesen auf einen Precharge-Pegel (VPC) vorgeladen werden (t1), **dadurch gekennzeichnet,** daß nach dem Vorladen (t1) auf die Bitleitungen (BL) und/oder auf die Referenzbitleitungen ($\overline{BL}$) jeweils ein zusätzliches Potential ($\Delta$VPC1,$\Delta$VPC2) eingekoppelt ($t_{CK}$;$t_{CK1}$,$t_{CK2}$) wird.

16. Verfahren nach Anspruch 15, **dadurch gekennzeichnet,** daß die zusätzlichen Potentiale ($\Delta$VPC1,$\Delta$VPC2) über Koppelkapazitäten (CK) eingekoppelt ($t_{CK}$;$t_{CK1}$,$t_{CK2}$) werden.

17. Verfahren nach Anspruch 15 oder 16, **dadurch gekennzeichnet,** daß das Einkoppeln ($t_{CK}$;$t_{CK1}$,$t_{CK2}$) mittels wenigstens eines Paares von Testsignalen (Test1,Test2;Test1$_i$,Test2$_i$) gesteuert wird.

18. Verfahren nach Anspruch 17, **dadurch gekennzeichnet,** daß das Einkoppeln ($t_{CK}$,$t_{CK1}$,$t_{CK2}$) mittels einer Flanke mindestens eines der Testsignale (Test1,Test2;Test1$_i$,Test2$_i$) erfolgt.

19. Verfahren nach Anspruch 18, **dadurch gekennzeichnet,** daß als Flanken positiven Flanken der Testsignale (Test1,Test2) benutzt werden.

20. Verfahren nach Anspruch 18, **dadurch gekennzeichnet,** daß als Flanken negative Flanken der Testsignale (Test1,Test2) benutzt werden.

21. Verfahren nach Anspruch 18, **dadurch gekennzeichnet,** daß als Flanken eine negative Flanke eines der beiden Testsignale (Test1;Test2) sowie eine positive Flanke des jeweils anderen der beiden Testsignale (Test2;Test1) benutzt werden.

22. Verfahren nach einem der Ansprüche 15 bis 21, **dadurch gekennzeichnet,** daß das Einkoppeln gleichzeitig ($t_{CK}$) durchgeführt wird.

23. Verfahren nach einem der Ansprüche 15 bis 21, **dadurch gekennzeichnet,** daß das Einkoppeln zu verschiedenen Zeiten ($t_{CK1}$,$t_{CK2}$) durchgeführt wird.

# FIG 1

CB

BL ($\overline{BL}$)

TT

VPL ⌐ MC ⌐ VPL

CSL

MC

VPL ⌐ VPL

CB

VPC  EQL  WL0  WL1 --- WL254 WL255  $\overline{SAN}$  SAP  DQ  $\overline{DQ}$

$\overline{BL}$ (BL)

PC

AMP

# FIG 3

Test1  Test2

CB

BL ($\overline{BL}$)

TT

CK

VPL ⌐ MC ⌐ VPL

CSL

CK

MC

VPL ⌐ VPL

CB

VPC  EQL  CTRL1  CTRL2  WL0  WL1 --- WL254 WL255  $\overline{SAN}$  SAP  DQ  $\overline{DQ}$

$\overline{BL}$ (BL)

PC

AMP

EP 0 387 378 A1

EP 0 387 378 A1

# FIG 2

| Signal | | Level |
|---|---|---|
| EQL | | VDD |
| | | VSS |
| | | VDD(+Vx) |
| WL | | VSS |
| $\overline{SAN}$ | | VPC |
| | | VSS |
| | | VDD |
| SAP | | VPC |
| | '1' | VDD |
| BL | | VPC |
| | '0' | VSS |
| | | VDD |
| $\overline{BL}$ | | VPC |
| | | VSS |

V1, V0

t1 t2 t3 t4 t5 t6 → t

# FIG 4

| Signal | | Level |
|---|---|---|
| EQL | | VDD |
| | | VSS |
| | | VDD(+Vx) |
| WL | | VSS |
| Test 2 | | Test-Hi |
| Test 1 | | Test-Lo |
| $\overline{SAN}$ | | VPC |
| | | VSS |
| | | VDD |
| SAP | | VPC |
| | '1' | VDD |
| BL | | VPC |
| | '0' | VSS |
| | | VDD |
| $\overline{BL}$ | | VPC |
| | | VSS |

$\Delta$VPC1, V0, V1, $\Delta$VPC2

t1 t$_{CK}$ t2 t3 t4 t5 t6 → t

FIG 5

# FIG 6

# FIG 7

EP 0 387 378 A1

# FIG 8

EQL — VDD (dashed), VSS

WL — VDD(+Vx), VSS (dashed)

Test 1 — Test-Hi1, Test-Lo1 (dashed)

Test 2 — Test-Hi 2, Test-Lo2 (dashed)

$\overline{\text{SAN}}$ — VPC (dashed), VSS

SAP — VDD, VPC

BL — ΔVPC1, V0, V1, '1', VDD, VPC, VSS, '0'

$\overline{\text{BL}}$ — ΔVPC2, VDD, VPC, VSS

t1  $t_{CK1}$  t2  $t_{CK2}$  t3  t4  →  t

# FIG 9

EP 0 387 378 A1

FIG 10

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-2 462 220  (SIEMENS)<br>* Insgesamt *<br>--- | 1 | G 11 C   11/24 |
| X | IBM TECHNICAL DISCLOSURE BULLETIN, Band 20, Nr. 11A, April 1978, Seiten 4297-4298, New York, US; R.H. LINTON: "Technique for optimizing signals in dynamic memory systems"<br>* Insgesamt *<br>--- | 1,4-8, 14 | |
| A | IDEM<br>--- | 15,16 | |
| A | IBM TECHNICAL DISCLOSURE BULLETIN, Band 22, Nr. 1, Juni 1979, Seiten 56-57, New York, US; K.S. GRAY et al.: "Sense amplifier signal margin circuit"<br>* Insgesamt *<br>--- | 1,14 | |
| A | IBM TECHNICAL DISCLOSURE BULLETIN, Band 28, Nr. 11, April 1986, Seiten 4792-4793, New York, US; "Signal margin test for 4-D, 4-D with poly load or 6-D random-access memories"<br>* Insgesamt *<br>----- | 1,4,5,9 ,13 | **RECHERCHIERTE SACHGEBIETE (Int. Cl.5)**<br><br>G 11 C   11/24<br>G 11 C   29/00 |

Der vorliegende Recherchenbericht wurde für alle Patentansprüche erstellt

| Recherchenort | Abschlußdatum der Recherche | Prüfer |
|---|---|---|
| DEN HAAG | 28-12-1989 | DEGRAEVE L.W.G. |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
..............................................................................................
& : Mitglied der gleichen Patentfamilie, übereinstimmendes
    Dokument